# EUROPEAN PATENT APPLICATION

(11) **EP 3 734 821 A1**
(43) Date of publication of application: **04.11.2020**
(21) Application number: 18894659.4
(22) Date of filing: 09.05.2018
(51) Int. Cl.: H02M 1/42

(54) **POWER FACTOR CORRECTION CIRCUIT CONTROL METHOD AND DEVICE**

(30) Priority: 29.12.2017 CN 201711489322
(71) Applicant: Vertiv Corporation, Columbus, OH 43329 (US)
(72) Inventor: XIANG, Bo, Shenzhen, Guangdong 518055 (CN); LI, Jian, Shenzhen, Guangdong 518055 (CN); YANG, Ruiguo, Shenzhen, Guangdong 518055 (CN)
(74) Representative: Harden, Henry Simon
(86) International application number: PCT/CN2018/086120
(87) International publication number: WO 2019/128033

(57) **Abstract**

Disclosed in the present invention are a control method and device for a power factor correction circuit. The method comprises: obtaining voltage information of the power factor correction circuit; determining whether the voltage information meets a set switching condition; if the set switching condition is met, switching a control mode of the power factor correction circuit to a continuous conduction mode; and if the set switching condition is not met, switching the control mode of the power factor correction circuit to a triangular wave current mode or a critical conduction mode. Compared with the prior art, the control mode of the power factor correction circuit can be different according to the voltage information in the embodiment of the present invention, instead of remaining unchanged at all times, without increasing the withstand voltage level of the bus capacitor, thereby reducing the cost of implementation. Moreover, it is not necessary to forcibly change a given value of the current peak, thereby improving the total harmonic distortion of the input current.

## Description

### FIELD

The present disclosure relates to the field of control technologies, and in particular to a method and a device for controlling a power factor correction circuit.

### BACKGROUND

In order to ensure high efficiency of a power factor correction circuit (specifically, a totem-pole power factor correction circuit), the power factor correction circuit generally operates in a critical-conduction mode (CRM) or a triangular current mode (TCM). However, in this case, in a case that an output voltage of the power factor correction circuit is approximate to an input voltage of the power factor correction circuit, a current flowing through an inductor in the power factor correction circuit may be not reduced, or may be reduced to zero or a fixed negative value after a long time period elapses, such that the power factor correction circuit cannot be driven normally in a next period, which may result in instability of the power factor correction circuit and may even affect the normal operation of the power factor correction circuit.

At present, the following two methods are generally adopted to solve the above problems.

In a first method, a voltage-withstand level of a bus capacitor in the power factor correction circuit is improved, such that a voltage difference between the output voltage and the input voltage of the power factor correction circuit is increased. However, after the voltage-withstand level of the bus capacitor is improved, a capacity of a capacitor is greatly reduced under a same volume, which may result in a decrease in power density or other electrical performances, and also may result in a high cost.

In a second method, a given current peak value of the inductor in the power factor correction circuit is reduced (or an on-time period Ton is reduced), such that the current flowing through the inductor may be rapidly reduced to zero, so as to quickly start a next switching period. However, the forcedly changing the given current peak value (or the on-time period Ton) may result in the waveform of an input current being a non-sinusoidal waveform, may further result in a severe problem in a total harmonic distortion (THD) of the power factor correction circuit.

That is, problems of the high cost of implementation and the severe THD exist in the conventional method for controlling a power factor correction circuit.

### SUMMARY

A method and a device for controlling a power factor correction circuit are provided according to the embodiments of the present disclosure, to solve the problems of a high cost of implementation and a severe THD existing in the conventional method for controlling the power factor correction circuit.

A method for controlling a power factor correction circuit is provided according to an embodiment of the present disclosure. The method includes: acquiring voltage information of the power factor correction circuit; determining whether the voltage information meets a set switching condition; switching a control mode of the power factor correction circuit to be a continuous conduction mode, if the voltage information meets the set switching condition; and switching the control mode of the power factor correction circuit to be a triangular current mode or a critical-conduction mode, if the voltage information does not meet the set switching condition.

In an embodiment, the voltage information is information related to a maximum instantaneous value of an input voltage of the power factor correction circuit, and determining whether the voltage information meets the set switching condition including: determining that the voltage information meets the set switching condition, if the maximum instantaneous value of the input voltage of the power factor correction circuit is greater than a preset maximum threshold.

In an embodiment, the voltage information is information related to an effective value of an input voltage of the power factor correction circuit in a set first period, and determining whether the voltage information meets the set switching condition including: determining that the voltage information meets the set switching condition, if the effective value of the input voltage of the power factor correction circuit in a set first period is greater than a preset effective threshold.

In an embodiment, the voltage information is information related to an average value of an input voltage of the power factor correction circuit in a set second period, and determining whether the voltage information meets the set switching condition including: determining that the voltage information meets the set switching condition, if the average value of the input voltage of the power factor correction circuit in a set second period is greater than a preset average threshold.

In an embodiment, the voltage information is information related to a voltage difference between an output voltage and an input voltage of the power factor correction circuit; and determining whether the voltage information meets the set switching condition including: determining that the voltage information meets the set switching condition, if the voltage difference value between the output voltage and the input voltage of the power factor correction circuit is less than a preset difference threshold.

Accordingly, a device for controlling a power factor correction circuit is provided according to an embodiment of the present disclosure. The device includes: an acquiring module configured to acquire voltage information of the power factor correction circuit; a determining module configured to determine whether the voltage information meets a set switching condition; and a control module configured to switch a control mode of the power factor correction circuit to be a continuous conduction mode, if the voltage information meets the set switching condition, and to switch the control mode of the power factor correction circuit to be a triangular current mode or a critical-conduction mode, if the voltage information does not meet the set switching condition.

In an embodiment, the voltage information is information related to a maximum instantaneous value of an input voltage of the power factor correction circuit, and the determining module is further configured to determine that the voltage information meets the set switching condition, if the maximum instantaneous value of the input voltage of the power factor correction circuit is greater than a preset maximum threshold.

In an embodiment, the voltage information is information related to an effective value of an input voltage of the power factor correction circuit in a set first period, and the determining module is further configured to determine that the voltage information meets the set switching condition, if the effective value of the input voltage of the power factor correction circuit in a set first period is greater than a preset effective threshold.

In an embodiment, the voltage information is information related to an average value of an input voltage of the power factor correction circuit in a set second period, and the determining module is further configured to determine that the voltage information meets the set switching condition, if the average value of the input voltage of the power factor correction circuit in a set second period is greater than a preset average threshold.

In an embodiment, the voltage information is information related to a voltage difference between an output voltage and an input voltage of the power factor correction circuit, and the determining module is further configured to determine that the voltage information meets the set switching condition, if the voltage difference between the output voltage and the input voltage of the power factor correction circuit is less than a preset difference threshold.

Further, a computing device is provided according to an embodiment of the present disclosure. The computing device includes a memory and a processor, where the memory is configured to store program instructions, and the processor is configured to call the program instructions stored in the memory and perform, in accordance with the obtained program, the method for controlling a power factor correction circuit according to the embodiments of the present disclosure.

Furthermore, a computer storage medium having stored thereon computer executable instructions is provided according to an embodiment of the present disclosure. The computer executable instructions are used to cause a computer to perform the method for controlling a power factor correction circuit according to the embodiments of the present disclosure.

The present disclosure has the following beneficial effects.

A method and a device for controlling a power factor correction circuit are provided according to the embodiments of the present disclosure. The method and device may be used to: acquire voltage information of the power factor correction circuit; determine whether the voltage information meets the set switching condition; switch the control mode of the power factor correction circuit to be the CCM, if the voltage information meets the set switching condition; and switch the control mode of the power factor correction circuit to be the TCM or the CRM, if the voltage information does not meet the set switching condition. Compared with the conventional technology, the method for controlling a power factor correction circuit provided in the embodiments of the present disclosure may vary according to the voltage information, rather than being unchanged. Further, it is not required to improve the voltage-withstand level of a bus capacitor, such that the cost of implementation can be reduced. In addition, it is not required to forcedly change the given current peak value (or the on-time period Ton), such that the THD of an input current can be improved.

### BRIEF DESCRIPTION OF THE DRAWINGS

In order to more clearly illustrate technical solutions according to embodiments of the present disclosure, drawings used in the description of the embodiments are briefly described below. It is apparent that the drawings in the following description show merely some embodiments of the present disclosure, and other drawings may be obtained based on these drawings by those skilled in the art without any creative effort.
Figure 1 is a flowchart of a method for controlling a power factor correction circuit according to a first embodiment of the present disclosure;
Figure 2 is a schematic structural diagram of a first totem-pole power factor correction circuit according to the first embodiment of the present disclosure;
Figure 3 is a schematic structural diagram of a second totem-pole power factor correction circuit according to the first embodiment of the present disclosure;
Figure 4 is a schematic structural diagram of a device for controlling a power factor correction circuit according to a second embodiment of the present disclosure; and
Figure 5 is a schematic structural diagram of a computing device according to a third embodiment of the present disclosure.

### DETAILED DESCRIPTION OF EMBODIMENTS

In order to make objects, technical solutions and advantages of the present disclosure more clear, the present disclosure is further described in detailed below in conjunction with the drawings. It is apparent that, the described embodiments are only some embodiments of the present disclosure, rather than all embodiments. Based on the embodiments of the present disclosure, all other embodiments obtained by those skilled in the art without any creative effort fall within the protection scope of the present disclosure.

### First Embodiment

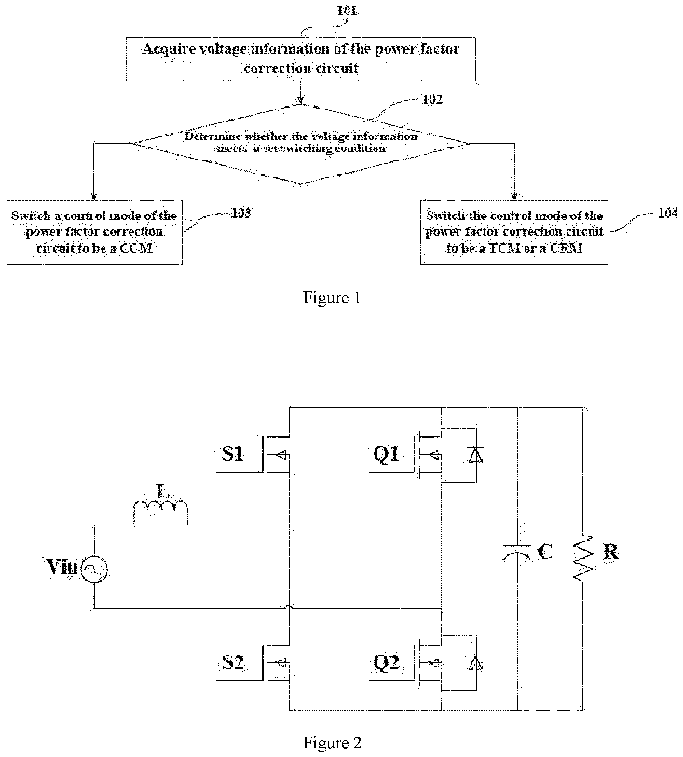

In order to solve the problems of the high cost of implementation and the severe THD exist in the conventional method for controlling the power factor correction circuit, a method for controlling a power factor correction circuit is provided according to the first embodiment of the present disclosure, as shown in Figure 1, which is a flowchart of a method for controlling a power factor correction circuit according to the first embodiment of the present disclosure. Specifically, as shown in Figure 1, the method for controlling a power factor correction circuit includes step 101 to step 104.

In step 101, voltage information of the power factor correction circuit is acquired.

In step 102, whether the voltage information meets a set switching condition is determined.

In step 103, a control mode of the power factor correction circuit is switched to be a continuous Current mode (CCM), if the voltage information meets the set switching condition.

In step 104, the control mode of the power factor correction circuit is switched to be a TCM or a CRM, if the voltage information does not meet the set switching condition.

That is, in the embodiment of the present disclosure, the voltage information of the power factor correction circuit may be acquired; whether the voltage information meets the set switching condition may be determined; and the control mode of the power factor correction circuit may be switched to be the CCM, if the voltage information meets the set switching condition, and the control mode of the power factor correction circuit may be switched to be the TCM or the CRM, if the voltage information does not meet the set switching condition. Compared with the conventional technology, the method for controlling a power factor correction circuit provided in the embodiments of the present disclosure may vary according to the voltage information, rather than being unchanged. Further, it is not required to improve the voltage-withstand level of a bus capacitor, such that the cost of implementation can be reduced. In addition, it is not required to forcedly change the given current peak value (or the on-time period Ton), such that the THD of an input current can be improved.

It should be noted that, the CCM controlling manner is a controlling manner based on a fixed frequency switch, even if the voltage difference between the output voltage and the input voltage of the power factor correction circuit is small, a next switching period can be normally driven when a set switching period arrives, which is not repeated herein.

In an embodiment, the power factor correction circuit according to an embodiment of the present disclosure may generally be a totem-pole power factor correction circuit, as shown in Figure 2, which is a schematic structural diagram of a first totem-pole power factor correction circuit according to the first embodiment of the present disclosure. Specifically, as shown in Figure 2, the totem-pole power factor correction (PFC) circuit may include an inductor L, a first branch formed by a first high-frequency transistor S1 and a second high-frequency transistor S2 connected in series with each other, and a second branch formed by a first power-frequency transistor Q1 and a second power-frequency transistor Q2 connected in series with each other. The first branch is connected in parallel with the second branch. One terminal of a parallel branch formed by the first branch and the second branch is connected to one terminal of a bus capacitor C and one terminal of a load resistor R, and the other terminal of the parallel branch is connected to other terminal of the bus capacitor C and other terminal of the load resistor R. In Figure 2, Vin represents the input voltage of the power factor correction circuit.

In an embodiment, the high-frequency transistor in the power factor correction circuit provided in an embodiment of the present disclosure may generally be a gallium nitride (GaN) transistor. It should be noted that, the high-frequency transistor in the power factor correction circuit provided in an embodiment of the present disclosure may also be implemented by other switch transistors, such as a silicon carbide (SiC) transistor or an insulated gate bipolar transistor (IGBT) and the like, as long as the transistor has the low reverse recovery function, which is not limited herein.

In an embodiment, the voltage information is information related to a maximum instantaneous value of the input voltage of the power factor correction circuit, and determining whether the voltage information meets the set switching condition including: determining that the voltage information meets the set switching condition, if the maximum instantaneous value of the input voltage of the power factor correction circuit is greater than a preset maximum threshold.

It should be noted that the preset maximum threshold may be flexibly set according to the actual situations. The preset maximum threshold may be set as, for example, 380V, 390V and the like, as long as the actual demands can be met, which is not limited herein.

In an example, it is assumed that the preset maximum threshold is set as 380V. If the maximum instantaneous value of the input voltage is 400V, it is determined that the voltage information meets the set switching condition. In this case, the control mode of the power factor correction circuit may be switched to be the CCM.

In another example, it is assumed that the preset maximum threshold is set as 380V. If the maximum instantaneous value of the input voltage is 360V, it is determined that the voltage information does not meet the set switching condition. In this case, the control mode of the power factor correction circuit may be switched to be the TCM or the CRM

It should be noted that, appropriate hysteresis strategy may be performed during the switching of the control mode, to ensure security and stability of the power factor correction circuit, which is not repeated herein.

In an embodiment, the voltage information is information related to an effective value of the input voltage of the power factor correction circuit in a set first period, and determining whether the voltage information meets the set switching condition including: determining that the voltage information meets the set switching condition, if the effective value of the input voltage of the power factor correction circuit in a set first period is greater than a preset effective threshold.

The set first period T1 may be flexibly set according to the actual situations. The set first period may be set as, for example, 1h (hour), lmin (minute), or Is (second) and the like, which is not limited herein.

It should be noted that the preset effective threshold may be flexibly set according to the actual situations. The preset effective threshold may be set as, for example, 270V, 290V and the like, as long as the actual demands can be met, which is not limited herein.

In an example, it is assumed that the preset effective threshold is set as 270V. If the effective value of the input voltage in the set first period is 300V, it is determined that the voltage information meets the set switching condition. In this case, the control mode of the power factor correction circuit may be switched to be the CCM.

In another example, it is assumed that the preset effective threshold is set as 270V. If the effective value of the input voltage in the set first period is 250V, it is determined that the voltage information does not meet the set switching condition. In this case, the control mode of the power factor correction circuit may be switched to be the CRM or the TCM.

It should be noted that, appropriate hysteresis strategy may be performed during the switching of the control mode, to ensure security and stability of the power factor correction circuit, which is not repeated herein.

In an embodiment, the voltage information is information related to an average value of the input voltage of the power factor correction circuit in a set second period, and determining whether the voltage information meets the set switching condition including: determining that the voltage information meets the set switching condition, if the average value of the input voltage of the power factor correction circuit in the set second period is greater than a preset average threshold.

The set second period T2 may be flexibly set according to the actual situations. The set second period may be set as, for example, 1h (hour), lmin (minute), or Is (second) and the like. The set second period T2 and the set first period T1 may be set to be the same or different, which is not limited herein.

It should be noted that the preset average threshold may be flexibly set according to the actual situations. The preset average threshold may be set as, for example, 250V, 270V and the like, as long as the actual demands can be met, which is not limited herein.

In an example, it is assumed that the preset average threshold is set as 250V. If the average value of the input voltage in the set second period is 270V, it is determined that the voltage information meets the set switching condition. In this case, the control mode of the power factor correction circuit may be switched to be the CCM.

In another example, it is assumed that the preset average threshold is set as 250V. If the average value of the input voltage in the set second period is 230V, it is determined that the voltage information does not meet the set switching condition. In this case, the control mode of the power factor correction circuit may be switched to be the CRM or the TCM.

It should be noted that, appropriate hysteresis strategy may be performed during the switching of the control mode, to ensure security and stability of the power factor correction circuit, which is not repeated herein.

In an embodiment, the voltage information is information related to a voltage difference between the output voltage and the input voltage of the power factor correction circuit, and determining whether the voltage information meets a set switching condition including: determining that the voltage information meets the set switching condition, if the voltage difference between the output voltage and the input voltage of the power factor correction circuit is less than a preset difference threshold.

Specifically, the voltage difference between the output voltage and the input voltage of the power factor correction circuit may generally be an instantaneous value of a voltage difference ΔV between the output voltage and the input voltage of the power factor correction circuit, which is not repeated herein.

It should be noted that the preset difference threshold may be flexibly set according to the actual situations. The preset difference threshold may be set as, for example 10V, 20V and the like, as long as the actual demands can be met, which is not limited herein.

In an example, it is assumed that the preset difference threshold is set as 30V. If the input voltage Vin is 400V and the output voltage Vout is 420V, that is, the voltage difference between the input voltage and the output voltage is 20V, it is determined that the voltage information meets the set switching condition. In this case, the control mode of the power factor correction circuit may be switched to be the CCM.

In another example, it is assumed that the preset difference threshold is set as 30V. If the input voltage Vin is 380V and the output voltage Vout is 420V, that is, the voltage difference between the input voltage and the output voltage is 40V, it is determined that the voltage information does not meet the set switching condition. In this case, the control mode of the power factor correction circuit may be switched to be the CRM or the TCM.

It should be noted that, appropriate hysteresis strategy may be performed during the switching of the control mode, to ensure security and stability of the power factor correction circuit, which is not repeated herein.

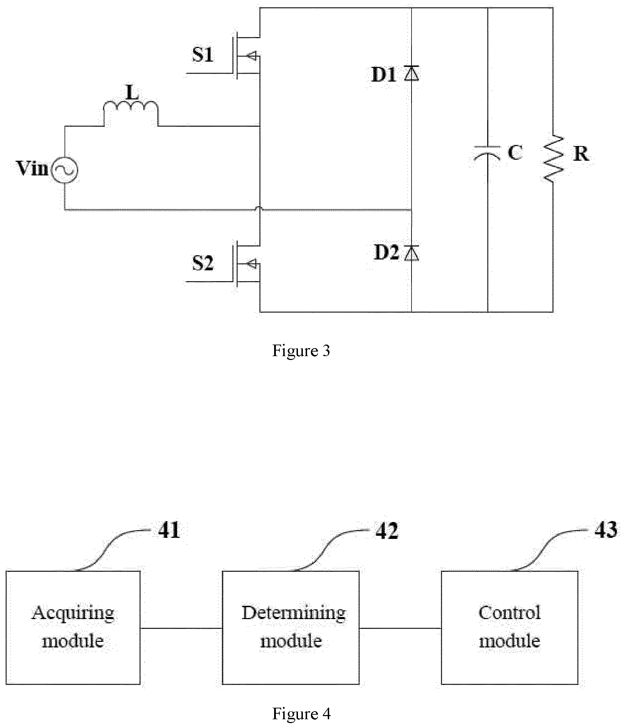

Further, Figure 3 is a schematic structural diagram of a second totem-pole power factor correction circuit according to the first embodiment of the present disclosure. The totem-pole power factor correction circuit shown in Figure 3 differs from the totem-pole power factor correction circuit shown in Figure 2 in that: the first power frequency transistor Q1 and the second power frequency transistor Q2 in Figure 2 are replaced with two diodes D1 and D2 in Figure 3, respectively. Specifically, in an embodiment of the present disclosure, the first power frequency transistor Q1 and the second power frequency transistor Q2 of the second branch in the power factor correction circuit shown in Figure 2 may be the diodes D1 and D2 shown in Figure 3.

It should be noted that, the power factor correction circuit provided in an embodiment of the present disclosure may be a power factor correction circuit with other structures, as long as the power factor correction circuit is a totem-pole power factor correction circuit, which is not repeated herein.

A method for controlling a power factor correction circuit is provided according to embodiments of the present disclosure. The method includes: acquiring voltage information of the power factor correction circuit; determining whether the voltage information meets a set switching condition; switching a control mode of the power factor correction circuit to be the CCM, if the voltage information meets the set switching condition; and switching the control mode of the power factor correction circuit to be the TCM or the CRM, if the voltage information does not meet the set switching condition. Compared with the conventional technology, the method for controlling a power factor correction circuit provided in the embodiments of the present disclosure may vary according to the voltage information, rather than being unchanged. Further, it is not required to improve the voltage-withstand level of a bus capacitor, such that the cost of implementation can be reduced. In addition, it is not required to forcedly change the given current peak value (or the on-time period Ton), such that the THD of an input current can be improved.

### Second Embodiment

Based on the same inventive concept as the first embodiment of the present disclosure, a device for controlling a power factor correction circuit is provided according to the second embodiment. Figure 4 is a schematic structural diagram of a device for controlling a power factor correction circuit according to the second embodiment of the present disclosure. Specifically, as shown in Figure 4, the device for controlling a power factor correction circuit includes an acquiring module 41, a determining module 42 and a control module 43.

The acquiring module 41 is configured to acquire voltage information of the power factor correction circuit.

The determining module 42 is configured to determine whether the voltage information meets a set switching condition.

The controlling module 43 is configured to switch a control mode of the power factor correction circuit to be a continuous conduction mode CCM, if the voltage information meets the set switching condition; and to switch the control mode of the power factor correction circuit to be a triangular current mode TCM or a critical-conduction mode CRM, if the voltage information does not meet the set switching condition.

That is, the device for controlling a power factor correction circuit according to an embodiment of the present disclosure includes: the acquiring module configured to acquire voltage information of the power factor correction circuit; the determining module configured to determine whether the voltage information meets the set switching condition; and the control module configured to switch the control mode of the power factor correction circuit to be the CCM, if the voltage information meets the set switching condition, and to switch the control mode of the power factor correction circuit to be the TCM or the CRM, if the voltage information does not meet the set switching condition. Compared with the conventional technology, the method for controlling a power factor correction circuit provided in the embodiments of the present disclosure may vary according to the voltage information, rather than being unchanged. Further, it is not required to improve the voltage-withstand level of a bus capacitor, such that the cost of implementation can be reduced. In addition, it is not required to forcedly change the given current peak value (or the on-time period Ton), such that the THD of an input current can be reduced.

In an embodiment, a high-frequency transistor in the power factor correction circuit provided in an embodiment of the present disclosure may generally be a gallium nitride (GaN) transistor. It should be noted that, the high-frequency transistor in the power factor correction circuit provided in an embodiment of the present disclosure may also be implemented by other switching transistors, such as a silicon carbide (SiC) transistor or an insulated gate bipolar transistor (IGBT) and the like, as long as the transistor has the low reverse recovery function, which is not limited herein.

In an embodiment, the voltage information is information related to a maximum instantaneous value of an input voltage of the power factor correction circuit, and the determining module 42 may be further configured to determine that the voltage information meets the set switching condition, if the maximum instantaneous value of the input voltage of the power factor correction circuit is greater than a preset maximum threshold.

It should be noted that the preset maximum threshold may be flexibly set according to the actual situations. The preset maximum threshold may be set as, for example, 380V, 390V and the like, as long as the actual demands can be met, which is not limited herein.

Specifically, the voltage information is information related to an effective value of the input voltage of the power factor correction circuit in a set first period, and the determining module 42 may be further configured to determine that the voltage information meets the set switching condition, if the effective value of the input voltage of the power factor correction circuit in a set first period is greater than a preset effective threshold.

The set first period T1 may be flexibly set according to the actual situations. The set first period may be set as, for example, 1h (hour), lmin (minute), or Is (second) and the like, which is not limited herein.

It should be noted that the preset effective threshold may be flexibly set according to the actual situations. The preset effective threshold may be set as, for example, 270V, 290V and the like, as long as the actual demands can be met, which is not limited herein.

In an embodiment, the voltage information is information related to an average value of the input voltage of the power factor correction circuit in a set second period, and the determining module 42 may be further configured to determine that the voltage information meets the set switching condition, if the average value of the input voltage of the power factor correction circuit in a set second period is greater than a preset average threshold.

The set second period T2 may be flexibly set according to the actual situations. The set second period may be set as, for example, 1h (hour), 1min (minute), or Is (second) and the like. The set second period T2 and the set first period T1 may be set to be the same or different, which is not limited herein.

It should be noted that the preset average threshold may be flexibly set according to the actual situations. The preset average threshold may be set as, for example, 250V, 270V and the like, as long as the actual demands can be met, which is not limited herein.

Specifically, the voltage information is information related to a voltage difference between the output voltage and the input voltage of the power factor correction circuit, and the determining module 42 may be further configured to determine that the voltage information meets the set switching condition, if the voltage difference between the output voltage and the input voltage of the power factor correction circuit is less than a preset difference threshold.

It should be noted that the preset difference threshold may be flexibly set according to the actual situations. The preset difference threshold may be set as, for example, 10V, 20V and the like, as long as the actual demands can be met, which is not limited herein.

A device for controlling a power factor correction circuit is provided according to the second embodiment of the present disclosure. The device includes: the acquiring module configured to acquire voltage information of the power factor correction circuit; the determining module configured to determine whether the voltage information meets the set switching condition; the control module configured to switch the control mode of the power factor correction circuit to be the CCM, if the voltage information meets the set switching condition, and to switch the control mode of the power factor correction circuit to be the TCM or the CRM, if the voltage information does not meet the set switching condition. Compared with the conventional technology, the method for controlling a power factor correction circuit provided in the embodiments of the present disclosure may vary according to the voltage information, rather than being unchanged. Further, it is not required to improve the voltage-withstand level of a bus capacitor, such that the cost of implementation can be reduced. In addition, it is required to forcedly change the given current peak value (or the on-time period Ton), such that the THD of an input current can be improved.

### Third Embodiment

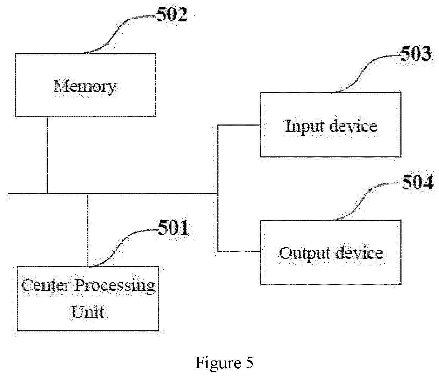

A computing device is provided according to the third embodiment of the present disclosure, as shown in Figure 5, which is a schematic structural diagram of the computing device according to the third embodiment of the present disclosure. The computing device may be a desktop computer, a portable computer, a smart phone, a tablet computer, a personal digital assistant (PDA) and the like. Specifically, the computing device according to an embodiment of the present disclosure may include a processor, such as a center processing unit (CPU) 501, a memory 502, an input device 503, and an output device 504, and the like. The input device 503 may include a keyboard, a mouse, a touch screen and the like. The output device 504 may include a display device such as a liquid crystal display (LCD), a cathode ray tube (CRT) and the like.

The memory 502 may include a read only memory (ROM) and a random access memory (RAM), and provides program instructions and data stored in the memory 502 to the center processing unit (CPU) 501. In an embodiment of the present disclosure, the memory 502 may be used to store programs of the method for controlling a power factor correction circuit.

By calling program instructions stored in the memory 502, the center processing unit (CPU) 501 may be used to perform the following in accordance with the obtained program: acquiring voltage information of the power factor correction circuit; determining whether the voltage information meets a set switching condition; switching a control mode of the power factor correction circuit to be a continuous conduction mode CCM, if the voltage information meets the set switching condition; and switching the control mode of the power factor correction circuit to be a triangular current mode TCM or a critical-conduction mode CRM, if the voltage information does not meet the set switching condition.

### Fourth Embodiment

A computer storage medium is provided according to the fourth embodiment of the present disclosure, which is configured to store computer program instructions used by the above computer devices. The computer program instructions include programs used to perform the method for controlling a power factor correction circuit.

The computer storage medium may be any available medium or a data storage device capable of being accessed by a computer, which includes but is not limited to a magnetic memory (for example, a floppy disk, a hard disk, a magnetic tape, a magnetic-optical disk (MO) and the like), an optical memory (for example, a CD, a DVD, a BD, a HVD and the like), and a semiconductor memory (for example, an ROM, an EPROM, a EEPROM, a non-volatile memory (NAND FLASH), a solid state disk (SSD)) and the like.

It should be understood by those skilled in the art that, the embodiments of the present disclosure may be implemented as methods, devices (apparatuses) or computer grogram products. Therefore, the present disclosure may be implemented by only hardware embodiments, only software embodiments or embodiments combining software with hardware. Alternatively, the present disclosure may be implemented as computer program products implemented on one or more computer available storage mediums (including but not limit to a magnetic disk memory, a CD-ROM, an optical memory and the like) including computer available program codes.

The present disclosure is described with reference to flowcharts and/or block diagrams of the methods, devices (apparatuses) and computer program products according to the embodiments of the present disclosure. It should be understood that, each flow and/or block in the flowcharts and/or block diagrams and a combination of flows and/or blocks in the flowcharts and/or block diagrams may be implemented by computer program instructions. The computer program instructions may be provided to a general-purpose computer, a dedicated computer, an embedded processor or processors of other programmable data processing devices to generate a machine, such that the instructions executed by the computer or the processors of the other programmable data processing devices generate a device for implementing functions specified in one or more flows of the flowcharts and/or one or more blocks of the block diagrams.

The computer program instructions may also be stored in a computer-readable memory which may guide the computer or other programmable data processing devices to operate in a certain manner, such that the instructions stored in the computer-readable memory generate an product including an instruction device which implements functions specified in one or more flows of the flowcharts and/or one or more blocks of the block diagrams.

The computer program instructions may also be loaded to the computer or other programmable data processing devices, such that the computer or other programmable devices perform a series of operation steps to generate processing implemented by the computer, and thus the instructions executed on the computer or other programmable devices provide steps for implementing functions specified in one or more flows of the flowcharts and/or one or more blocks of the block diagrams.

Although the preferred embodiments of the present disclosure are described, those skilled in the art may make additional changes and modifications to the embodiments once they know the basic creative concepts. Therefore, the appended claims are intended to be explained as including the preferred embodiments and all changes and modifications falling within the scope of the present disclosure.

It is apparent that, those skilled in the art may make various changes and variations to the present disclosure without departing from the spirit and scope of the present disclosure. In this case, if the changes and variations of the present disclosure fall within the scope of the claims of the present disclosure and equivalent technologies thereof, the present disclosure is intended to include the changes and variations.

## Claims

1. A method for controlling a power factor correction circuit, wherein the method is **characterized by** comprising:
acquiring voltage information of the power factor correction circuit;
determining whether the voltage information meets a set switching condition;
switching a control mode of the power factor correction circuit to be a continuous conduction mode CCM, if the voltage information meets the set switching condition; and
switching the control mode of the power factor correction circuit to be a triangular current mode TCM or a critical-conduction mode CRM, if the voltage information does not meet the set switching condition.

2. The method for controlling a power factor correction circuit according to claim 1, wherein
the voltage information is information related to a maximum instantaneous value of an input voltage of the power factor correction circuit; and
determining whether the voltage information meets the set switching condition comprises: determining that the voltage information meets the set switching condition, if the maximum instantaneous value of the input voltage of the power factor correction circuit is greater than a preset maximum threshold.

3. The method for controlling a power factor correction circuit according to claim 1, wherein
the voltage information is information related to an effective value of an input voltage of the power factor correction circuit in a set first period; and
determining whether the voltage information meets the set switching condition comprises: determining that the voltage information meets the set switching condition, if the effective value of the input voltage of the power factor correction circuit in the set first period is greater than a preset effective threshold.

4. The method for controlling a power factor correction circuit according to claim 1, wherein
the voltage information is information related to an average value of an input voltage of the power factor correction circuit in a set second period; and
determining whether the voltage information meets the set switching condition comprises: determining that the voltage information meets the set switching condition, if the average value of the input voltage of the power factor correction circuit in the set second period is greater than a preset average threshold.

5. The method for controlling a power factor correction circuit according to claim 1, wherein
the voltage information is information related to a voltage difference between an output voltage and an input voltage of the power factor correction circuit; and
determining whether the voltage information meets the set switching condition comprises: determining that the voltage information meets the set switching condition, if the voltage difference between the output voltage and the input voltage of the power factor correction circuit is less than a preset difference threshold.

6. A device for controlling a power factor correction circuit, wherein the device is **characterized by** comprising:
an acquiring module configured to acquire voltage information of the power factor correction circuit;
a determining module configured to determine whether the voltage information meets a set switching condition; and
a control module configured to switch a control mode of the power factor correction circuit to be a continuous conduction mode CCM, if the voltage information meets the set switching condition; and to switch the control mode of the power factor correction circuit to be a triangular current mode TCM or a critical-conduction mode CRM, if the voltage information does not meet the set switching condition.

7. The device for controlling a power factor correction circuit according to claim 6, wherein
the voltage information is information related to a maximum instantaneous value of an input voltage of the power factor correction circuit; and
the determining module is further configured to determine that the voltage information meets the set switching condition, if the maximum instantaneous value of the input voltage of the power factor correction circuit is greater than a preset maximum threshold.

8. The device for controlling a power factor correction circuit according to claim 6, wherein
the voltage information is information related to an effective value of an input voltage of the power factor correction circuit in a set first period; and
the determining module is further configured to determine that the voltage information meets the set switching condition, if the effective value of the input voltage of the power factor correction circuit in the set first period is greater than a preset effective threshold.

9. The device for controlling a power factor correction circuit according to claim 6, wherein
the voltage information is information related to an average value of an input voltage of the power factor correction circuit in a set second period; and
the determining module is further configured to determine that the voltage information meets the set switching condition, if the average value of the input voltage of the power factor correction circuit in the set second period is greater than a preset average threshold.

10. The device for controlling a power factor correction circuit according to claim 6, wherein
the voltage information is information relate to a voltage difference between an output voltage and an input voltage of the power factor correction circuit; and
the determining module is further configured to determine that the voltage information meets the set switching condition, if the voltage difference between the output voltage and the input voltage of the power factor correction circuit is less than a preset difference threshold.

11. A computing device, comprising a memory and a processor, wherein
the memory is configured to store program instructions; and
the processor is configured to call the program instructions stored in the memory and perform, in accordance with the obtained program, the method for controlling a power factor correction circuit according to any one of claims 1 to 5.

12. A computer storage medium having stored thereon computer executable instructions that cause a computer to perform the method for controlling a power factor correction circuit according to any one of claims 1 to 5.
